# EUROPEAN PATENT APPLICATION

(11) **EP 1 841 079 A1**
(43) Date of publication of application: **03.10.2007**
(21) Application number: 06711729.1
(22) Date of filing: 16.01.2006
(51) Int. Cl.: H03M 13/41, H04L 1/00

(54) **DIGITAL RECEIVER AND DECODING METHOD**

(30) Priority: 19.01.2005 JP 2005011345
(71) Applicant: Pioneer Design Corporation, Meguro-ku, Tokyo 153-8654 (JP)
(72) Inventor: TOKI, Katsuhiko, Nishimachi, Yamada, Kawagoe-shi, Saitam (JP)
(74) Representative: Bohnenberger, Johannes
(86) International application number: PCT/JP2006/300448
(87) International publication number: WO 2006/077794

(57) **Abstract**

It is an object of the present invention to provide an improved digital receiver which, even when a reception condition change exceeds an error correcting capability of Viterbi decoding, can effect an earlier restoration to improve the error correcting capability.

When a reception condition has deteriorated, a control unit 7 controls a switchover unit 4 to supply an initialization code D_{CLR} as switchover code Da to de-interleave unit 5. When a reception condition changes back to an acceptable state, judgment code Dcd is supplied as switchover code to the de-interleave unit 5 and further to Viterbi decoding unit 6 to effect a Viterbi decoding. Immediately after a reception condition has changed back from an unacceptable state to an acceptable state, a demodulation code Dsin based on an initialization code D_{CLR} formed when a reception condition has deteriorated and another demodulation code Dsin based on judgment code Dcd formed when a reception condition is acceptable, are all supplied from the de-interleave unit 5 to the Viterbi decoding unit 6 to effect a Viterbi decoding. However, since the demodulation code Dsin based on an initialization code D_{CLR} is a code not affecting presumption of Viterbi, the Viterbi decoding unit 6 can specify a path on which an inter-code distance will become minimum, and judge that an information code corresponding to state transition of the foregoing path is a code having the maximum likelihood, thereby making it possible to shorten a time period before it becomes possible to obtain an information not containing any error, thus quickly exhibiting an original error correcting capability and performing the Viterbi decoding.

## Description

### Technical Field

The present invention relates to a digital receiver which receives for example terrestrial digital broadcast and satellite digital broadcast or the like, particularly to a digital receiver having an improved error correcting capability.

### Background Technique

In recent years, digitization of broadcast has advanced and digital broadcast such as terrestrial digital broadcast, satellite digital broadcast or the like have been started as new broadcasting media.

For example, in order to provide a broadcast in a transmission form which is suitable not only for a fixed reception but also for a mobile reception, there has been in use an OFDM (Orthogonal Frequency Division Multiplexing) serving as a transmission-line coding method. By using an error correction technique exhibiting a strong capability of correcting a code error, it is possible to ensure a stabilized reception on a receiver side. For example, Japanese Unexamined Patent Application Publication No. 8-265185 discloses a digital broadcast receiver which performs a strong error correction by Viterbi-decoding a broadcast coded in error correction and transmitted thereto, thereby ensuring a stabilized reception.

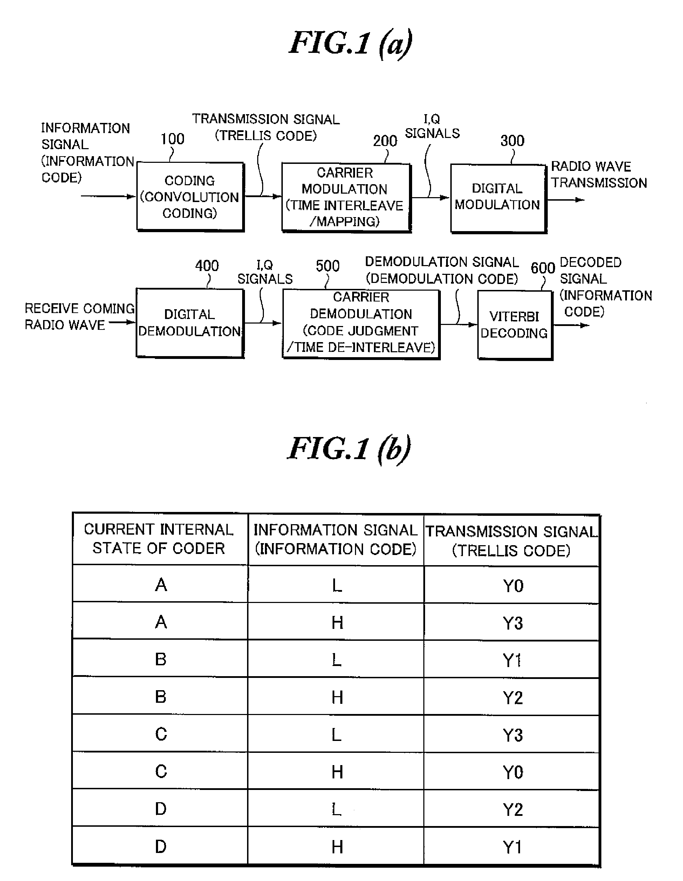

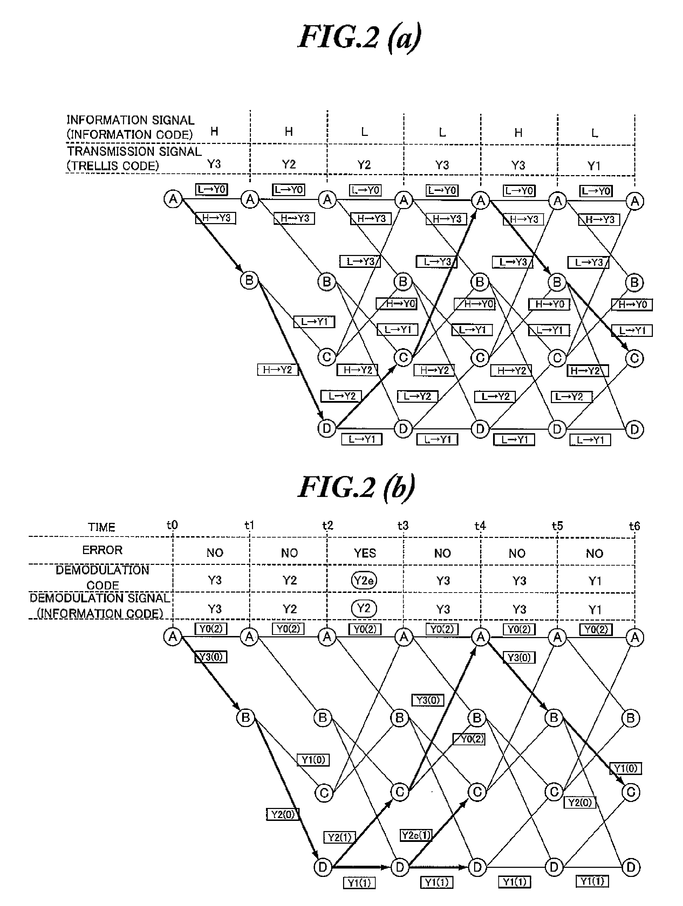

Here, description will be given to briefly explain a terrestrial digital broadcast system and Viterbi-decoding with reference to Figs. 1 and 2.

At first, the structure of a terrestrial digital broadcast system can be described as follows. As schematically shown in Fig. 1(a), on a broadcast station side, information signal (information code) to be transmitted is coded into transmission signal of trellis code by virtue of a coding unit 100 which has a predetermined state transition expressed by a trellis diagram, followed by a time interleave processing and a mapping processing in a carrier modulation unit 200, thereby effecting a digital modulation in a digital modulation unit 300 and transmitting a radio wave. On the other hand, on a receiver side receiving a coming radio wave, a digital demodulation unit 400 demodulates a received radio wave to generate I, Q signals which are complex data, while a carrier demodulation unit 500 performs a code judgment (de-mapping) and a time de-interleave in accordance with the I, Q signals, thereby generating demodulation signals consisting of code (demodulation code) sequences equivalent to the trellis codes before being inputted into the carrier modulation unit 200 on the broadcast station side. Then, a Viterbi decoding unit 600 performs a Viterbi decoding in accordance with the demodulation signals, thereby decoding a decoded signal equivalent to information signal (information code) transmitted by the broadcast station and thus outputting the signal.

Next, brief description will be given to explain the principle of Viterbi decoding. However, for the purpose of an easy explanation, the coding unit 100 is assumed to have a coding rate "1/2" and a restriction length "2". As shown in Fig. 1(b), once the coding unit 100 receives an information code L or H, trellis codes (in more detail, folding codes) Y0-Y3 will be outputted in response to the current internal states A-D, and will be transited to a predetermined internal state among the internal states A-D.

For example, when a current internal state is A, trellis code Y0 will be outputted and transited to the internal state A if information code L has been inputted, or trellis code Y3 is outputted and transited to an internal state B if information code H has been inputted. Then, if a trellis diagram is drawn to indicate a relation between an input/output and a state transition with respect to current internal state, it is possible to draw a diagram as shown in Fig. 2(a), so that the coding unit 100 can perform a coding processing in accordance with the trellis diagram.

As shown in Fig. 2(a), circular marks A-D represent internal states possible for the coding unit 100 to obtain, while notations such as "L->Y0" and "H->Y3" indicated on paths passing between the internal states are used to show that signal is coded into a trellis code Y0 and then outputted once information code L is inputted, or coded into a trellis code Y3 and then outputted once information code H is inputted.

Then, once information codes H, H, L, L, H, and L are inputted in this order into the coding unit 100 with its initial internal state at A, trellis codes Y3, Y2, Y2, Y3, Y3, and Y1 will be generated in this order and then outputted. Further, paths represented by thick lines carrying arrows in Fig. 2 (a) are used to represent the state transitions of the trellis codes Y3, Y2, Y2, Y3, Y3 with respect to information codes H, H, L, L, H, and L.

On the other hand, the Viterbi decoding unit 600 on the receiver side is provided to store data indicating the function of the coding unit 100 shown in Fig. 1(b), i.e., data indicating the internal states A-D and the state transitions of the paths shown in the trellis diagram of Fig. 2(a), thereby Viterbi-decoding demodulation codes in accordance with the foregoing data. Namely, in the Viterbi-decoding, a path on which an inter-code distance becomes minimum is specified, which inter-code distance is defined as a distance between a code relating to a state transition of the foregoing data and a demodulation code which has been code-judged and time de-interleaved in the carrier demodulation unit 500. Then, the Viterbi-decoding performs a maximum likelihood assumption indicating that an information code corresponding to the state transition of the foregoing path is a code having a maximum likelihood. As a result, a demodulation code is generated which has the same code sequences as the information code transmitted from the broadcast station side.

For example, as shown in Fig. 2(b), respective demodulation codes Y3, Y2, (Y2e), Y3, Y3, and Y1 are inputted into the Viterbi decoding unit 600 at times t0, t1, t2, t3, t4, t5, and t6, while an error occurs in the demodulation code (Y2e). At this time, computation is performed to calculate inter-code distances between the respective demodulation codes Y3, Y2, (Y2e), Y3, Y3, Y1 and the codes Y0-Y3 relating to state transitions, thereby specifying path on which the inter-code distance becomes minimum, as shown by thick lines carrying arrows. Namely, Y3 and Y0 or the like represented by Y3(0) and Y0(2) or the like are codes relating to state transitions, while the values within the parenthesis and represented by (0) and(2) or the like are inter-code distances.

In this way, since the paths Y3(0), Y2(0), Y2(0), Y2(1), Y3(0), Y3(0), and Y1(0) starting from initial internal states A and passing through internal states B, D, C, A, B, and C with the passing of time will become shortest paths, it is possible to presume some state transitions represented by thick lines carrying arrows in Fig. 2(a) in accordance with the shortest paths. Further, it is possible to correct an error demodulation code (Y2e) into a code Y2 in accordance with the information codes Y3, Y2, Y2, Y3, Y3, and Y1 transmitted from a broadcast station side, thereby generating decoded signals which will become code sequences Y3, Y2, Y2, Y3, Y3, and Y1 which are the same as the information codes Y3, Y2, Y2, Y3, Y3, and Y1 transmitted from the broadcast station side.

Therefore, it is possible to ensure a stabilized reception on the receiver side by performing a strong correction based on the Viterbi decoding.

Patent Document 1: Japanese Unexamined Patent Application Publication No. 8-265185.

### Disclosure of the Invention

### Problem(s) to be Solved by the Invention

However, even if Viterbi decoding is performed, since there is a possibility that a reception will be performed under a bad reception condition exceeding an error correcting capability of the Viterbi decoding, an important task will be trying to further improve an error correcting capability.

Moreover, when Viterbi-decoding an information which has been de-interleaved, since information code is decoded not from a demodulation code of a short time period, but from a demodulation code of a long time period, there has been found the following problem described below. Namely, when a reception condition deteriorates from an acceptable state and then returns back to an acceptable state, Viterbi decoding will be carried out in accordance with a demodulation code formed when a reception condition has deteriorated and a demodulation code formed when the reception condition has returned back to an acceptable state. As a result, a delay time will occur until it becomes possible to exhibit an original error correcting capability and perform a Viterbi decoding. That is, even if a reception condition has returned back to an acceptable state and a Viterbi decoding is performed in accordance with an information code formed under an acceptable reception condition, since an information code formed when a reception condition has deteriorated will unfavorably affect the Viterbi decoding, the following problem will occur. Namely, it is impossible to exhibit an original error correcting capability and a delay time will occur until the vanishing of an undesired effect of an information code formed when a reception condition has deteriorated.

Moreover, for example, when a user has switched on his or her desired broadcasting channel, or when a channel of a broadcast station having an acceptable reception state is automatically selected by seeking or searching, or when a plurality of diversity antennas are switched over to obtain an acceptable reception condition, since a condition at this time is just the same as the above-described situation in which a reception condition changes, a delay time will occur until it becomes possible to exhibit an original error correcting capability of Viterbi decoding. As a result, it becomes impossible to quickly perform a changeover among broadcasting channels, an automatic station selection based on seeking or searching, and a switchover among diversity antennas.

The present invention has been accomplished in view of the above-discussed conventional problems, and it is an object of the invention to provide an improved digital receiver which, even when a reception condition change exceeds an error correcting capability of Viterbi decoding, can effect an earlier restoration to exhibit an original error correcting capability, thereby making it possible to improve the error correcting capability.

### Means for Solving the Problem(s)

An invention recited in claim 1 is a digital receiver which receives a digital broadcast, comprising: code judgment means which outputs a judgment code by performing code judgment on signals demodulated by demodulation means; switchover means which selects and outputs the judgment code or an initialization code not affecting presumption of Viterbi; de-interleave means for de-interleaving a code outputted from the switchover means; Viterbi decoding means for generating a decoded signal by Viterbi-decoding a code de-interleaved by the de-interleave means; and control means which judges a reception condition and which, when a reception condition is acceptable, controls the switchover means to supply the judgment code outputted from the code judgment means to the de-interleave means, and when a reception condition has deteriorated, controls the switchover means to supply the initialization code to the de-interleave means.

An invention recited in claim 2 is a digital receiver according to claim 1, wherein the control means judges whether a reception condition is acceptable in accordance with a detection result outputted from at least one of the following detection means including: synchronism error detection means for performing a synchronism detection on the signals demodulated by the demodulation means and detecting a synchronism error; bit error rate detection means for detecting a bit error rate of the judgment code outputted from the code judgment means; and error detection means for performing a cyclic redundancy check on the judgment code outputted from the code detection means.

An invention recited in claim 3 is a digital receiver according to claim 1 or 2, wherein the de-interleave means includes memory means for buffering a predetermined amount of the code outputted from the switchover means, de-interleaves the code buffered in the memory means and outputs the code to the Viterbi decoding means.

An invention recited in claim 4 is a digital receiver according to claim 3, wherein the de-interleave means includes memory control means for rewriting the information stored in the memory means into the same information as the initialization code.

### Brief Description of the Drawings

Fig. 1 provides a diagram showing a structure of a terrestrial digital broadcast system and a table showing functions of a coding unit provided on a broadcast station side.
Fig. 2 provides diagrams explaining principles of Viterbi decoding.
Fig. 3 is a block diagram showing a structure of a digital receiver formed according to one embodiment of the invention.
Fig. 4 is a block diagram showing a structure of a digital receiver formed according to a more detailed embodiment of the invention.

### Best Mode of Carrying Out the Invention

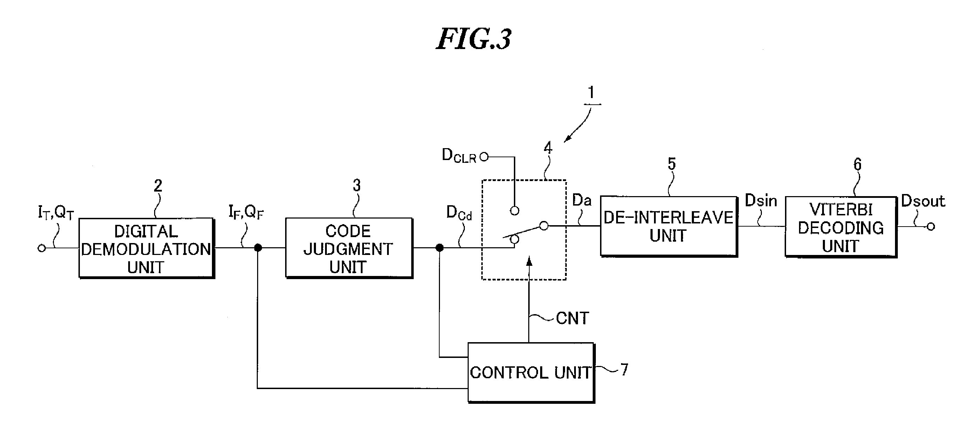

In the following, description will be given to explain a digital receiver which receives a digital broadcast such as a terrestrial digital broadcast, a satellite digital broadcast and the like, serving as a preferred embodiment of the present invention. Fig. 3 is a block diagram showing the structure of a digital receiver formed according to one embodiment of the present invention.

As shown in Fig. 3, the digital receiver 1 comprises: a digital demodulation unit 2; a code judgment unit 3; a switchover unit 4; a de-interleave unit 5; a Viterbi decoding unit 6; a control unit 7 controlling the switchover unit 4. Namely, a processing unit equivalent to the conventional carrier demodulation unit 500 shown in Fig. 1 (a) is composed of the code judgment unit 3, the switchover unit 4 and the de-interleave unit 5. The feature of the present embodiment is that the switchover unit 4, as well as the control unit 7 controlling the switchover unit 4, are provided between the code judgment unit 3 and the de-interleave unit 5.

The demodulation unit 2 A/D-converts and receives base-band signals I_{T} and Q_{T} quadrature-detected in a quadrature transformation unit (not shown), followed by performing an FFT processing (high speed Fourier transform) or the like, thereby converting the signals into quadrature signals I_{F} and Q_{F} which are complex data (I-axis data and Q-axis data).

The code judgment unit 3 performs code judgment on the quadrature signals I_{F} and Q_{F} to generate code Dcd (hereinafter, referred to as "judgment code") corresponding to coordinate position of signal point. Namely, the code judgment unit 3 judges signal points of quadrature signals I_{F} and Q_{F} on I-Q constellation, generates and outputs judgment code corresponding to coordinate position of signal point. When it is impossible to decide signal point, such as a condition in which quadrature signals I_{F} and Q_{F} are at their abnormal levels, the code judgment unit 3 will output, as judgment code Dcd, a predetermined code equivalent to a condition in which no quadrature signals I_{F} and Q_{F} are supplied. For example, when it is impossible to decide signal point, code (hereinafter, referred to as "D₀₀") formed when the coordinate positions of the I-axis and Q-axis on constellation are all 0 will be outputted as judgment code Dcd.

The switchover unit 4 is formed of a switching element having two inputs and one output, one of the two inputs constantly receives a value which is ignored when the Viterbi decoding unit 6 performs a Viterbi decoding, i.e., a value D_{CLR} which will not affect an assumption of the Viterbi (hereinafter, referred to as "initialization code"), while the other of the two inputs receives a judgment code Dcd outputted from the code judgment unit 3. Then, in accordance with a switchover control signal CNT outputted from the control unit 7, either a judgment code Dcd or an initialization code D_{CLR} is selected, while a selected code is supplied as a switchover code Da to the de-interleave unit 5.

Although the switchover unit 4 in the present embodiment is formed of a switching element, such a switchover unit can also be formed of other electronic element or circuit which will perform a switchover between a judgment code Dcd and an initialization code in accordance with a switchover control signal CNT and output a selected code.

The control unit 7 detects whether a reception condition is acceptable. If a reception condition is acceptable, the switchover unit 4 will be connected to the code judgment unit 3 in accordance with a switchover control signal CNT, and a judgment code Dcd will be supplied as switchover code Da to the de-interleave unit 5. On the other hand, if a reception condition has deteriorated, the switchover unit 4 will be disconnected from the code judgment unit 3 in accordance with a switchover control signal CNT, and initialization code D_{CLR} will be supplied as switchover code Da to the de-interleave unit 5.

Here, the control unit 7 in the present embodiment performs a synchronism detection based on quadrature signals I_{F}, and Q_{F}, outputted from the demodulation unit 2. If a synchronism error is smaller than a predetermined value, a reception condition will be judged as being acceptable. On the other hand, if a synchronism error is larger than a predetermined value, a reception condition will be judged as having been deteriorated. Furthermore, among judgment codes Dcd outputted from the code judgment unit 3, BER (Bit Error Rate) of a judgment code not time-interleaved is detected, and whether or not there is an error is detected based on CRC (Cyclic Redundancy Check), thereby detecting whether a reception condition is acceptable using these detection results. Then, if the results of the synchronism error, Bit Error Rate and Cyclic Redundancy Check all show that a reception condition is acceptable, the reception condition will be determined to be acceptable and the switchover unit 4 will be connected to the code judgment unit 3, so that a demodulation code Dcd will be transferred as a switchover code Da to the de-interleave unit 5. On the other hand, if any one of the results of the synchronism error, Bit Error Rate and Cyclic Redundancy Check shows a deterioration of a reception condition, an initialization code D_{CLR} will be outputted as a switchover code Da from the switchover unit 4 to the de-interleave unit 5.

In the present embodiment, the control unit 7 exactly judges whether a reception condition is acceptable based on the results of the synchronism error, Bit Error Rate and Cyclic Redundancy Check. However, it is also possible to judge whether a reception condition is acceptable using other physical information obtained through reception.

Moreover, in the present embodiment, when the results of the synchronism error, Bit Error Rate and Cyclic Redundancy Check all show that a reception condition is acceptable, the reception condition at this time will be determined to be acceptable. However, it is also possible to properly select one or more of the above information and judge that a reception condition is acceptable according to design specification or the like. Further, when all the above information show a deterioration of a reception condition, it is allowed to determine that a reception condition has deteriorated, and it is possible to properly select one or more of the above information and decide that a reception condition has deteriorated.

The de-interleave unit 5 receives a time-interleaved judgment code from among switchover codes Da, i.e., initialization code D_{CNT} and judgment code Dcd supplied through the switchover unit 4, and performs a time-interleave on the code which is then outputted to the Viterbi decoding unit 6, while at the same time being continuously buffered into a de-interleave memory (not shown) serving as an operation area.

Furthermore, the de-interleave unit 5 has a function of replacing some new information with information which is the same as initialization code D_{CLR} prior to buffering the new information. Such a replacement is performed when the digital receiver 1 of the present embodiment changes its reception frequency from a current broadcast being received to another broadcast in accordance with an instruction of a user or the like, or when a reception frequency is changed for automatically searching for a broadcast station having an acceptable reception condition by seeking or searching, or when buffering some new information not relating to the information stored in the de-interleave memory.

Namely, when a reception frequency is to be changed, since it is understood that there is no relation between the information buffered in the de-interleave memory and the information to be newly buffered by the coming reception or the like, the de-interleave unit 5 will perform a replacement to obtain the same information as the initialization code D_{CNT}, newly buffer the judgment code Dcd based on a next reception or the like, and perform a time de-interleave, all during a time period shorter than a time necessary for buffering, in the de-interleave memory, a switchover code Da supplied as an initialization code D_{CNT} from the switchover unit 4. In this way, the Viterbi decoding unit 6 will exhibit its original function soon after a reception frequency is changed or processed in other manner, without receiving any influence of information buffered in the de-interleave memory before reception frequency or the like is changed, thereby rendering it possible to decode a below-mentioned code Dsin which has been time de-interleaved in the de-interleave unit 5.

Viterbi decoding unit 6 operates to Viterbi-decode code Dsin which has been outputted from the de-interleave unit 5 and has been time de-interleaved, i.e., code (hereinafter, referred to as "demodulation code") equivalent to trellis code transmitted from a broadcast station side, thereby generating and thus outputting demodulation signal Dsout consisting of code equivalent to information code (i.e., code before coding) transmitted from the broadcast station side.

Next, description will be given to explain an operation of the digital receiver 1 of the present embodiment having the above-discussed structure. Specifically, the following description will explain a typical example in which a reception condition deteriorates from an acceptable state and then changes back to an acceptable state.

A fact that a reception state has deteriorated will be detected by the control unit 7 which controls the switchover unit 4 and supplies the initialization code D_{CLR} to the de-interleave unit 5, thereby carrying out a decoding process in the Viterbi decoding unit 6. In this way, when a reception state has deteriorated, it is inevitable that an effective decoding signal in relation to broadcast will no longer be outputted from the Viterbi decoding unit 6.

Next, once a reception state has changed back from a deteriorated state to an acceptable state, the control unit 7 will detect such an acceptable reception state and control the switchover unit 4, so as to supply the switchover code Da serving as judgment code Dcd to the de-interleave unit 5. Further, the de-interleave unit 5 will bit de-interleave the judgment code Dcd into demodulation signal Dsin and supply the same to the Viterbi decoding unit 6, thus effecting a Viterbi decoding.

Here, what one should pay attention to can be described as follows. Namely, immediately after a reception condition has changed from a deteriorated state to an acceptable state, and subsequent to the demodulation code Dsin based on the initialization code D_{CLR} formed when a reception condition has deteriorated, the demodulation code Dsin based on the judgment code Dcd formed when a reception state has become acceptable will be inputted from the de-interleave unit 5 to the Viterbi decoding unit 6. As a result, not only the demodulation code Dsin formed when a reception condition is acceptable, but also the demodulation code Dsin formed when a reception condition has deteriorated, can serve as so-called history information to perform Viterbi decoding.

However, the demodulation code Dsin serving as the foregoing history information is not the code which reflects a deteriorated reception state and then changes the same, but the demodulation code Dsin based on the initialization code D_{CLR} having a predetermined value. Accordingly, the Viterbi decoding unit can specify a path on which an inter-code distance will become minimum, and determine that an information code corresponding to state transition of the foregoing path is a code having a maximum likelihood, thereby making it possible to shorten a time period before it becomes possible to obtain information not containing any error.

For this reason, once a reception condition changes from a deteriorated state to an acceptable state, the Viterbi decoding unit 6 will soon exhibit an original error correcting capability, thereby making it possible to perform a Viterbi decoding.

As described above, the digital receiver 1 of the present embodiment is so formed that when a reception state is acceptable, the judgment code Dcd will be supplied to the Viterbi decoding unit 6 by way of the de-interleave unit 5, thereby effecting a Viterbi decoding. On the other hand, when a reception state has deteriorated, the initialization code D_{CLR} equivalent to a predetermined value will be supplied to the Viterbi decoding unit 6 by way of the de-interleave unit 5, thereby effecting a Viterbi decoding. In this way, if a reception state deteriorates and then changes back to an acceptable state, it is possible to quickly exhibit an original error correcting capability so as to perform a Viterbi decoding. As a result, it is possible to shorten a time period before sound and image are outputted to a speaker and a monitor or the like in which a reception state has returned to an acceptable state, thereby making it possible to provide a user with an acceptable operation performance or the like.

Moreover, when a reception state has deteriorated within a short time period during a reception, it is possible to reduce the occurrence of noise, thereby reducing a necessity of performing an appropriate mute processing for noise abasement, i.e., obtaining an advantage of omitting a precise mute adjustment which usually confronts some difficulties.

Further, when a reception frequency is changed in accordance with an instruction of a user or the like specifying a switchover to his or her desired broadcast channel, or when a reception frequency is changed for automatically selecting a broadcasting channel by seeking or searching for a channel of a broadcast station having an acceptable reception state, it is possible to effect the following operations. Namely, the de-interleave unit 5 will at an early time automatically rewrite the information stored in the de-interleave memory into the same information as the initialization code D_{CNT}, buffer the judgment signal Dcd whose reception frequency has been changed, thereby carrying out a time de-interleave. In this way, before a reception frequency is changed, it is possible to allow the Viterbi decoding unit 6 to quickly perform an original Viterbi decoding without receiving an influence of the information buffered in the de-interleave memory.

Although the present embodiment requires that when a reception frequency is to be changed as described above, the de-interleave unit 5 will at an early time automatically rewrite the information stored in the de-interleave memory into the same information as the initialization code D_{CNT}, it is also allowed not to carry out such a rewriting. Namely, when a reception frequency is to be changed, it is possible to buffer in the de-interleave memory the initialization code D_{CNT} supplied as switchover code Da from the switchover unit 4.

In this way, when the stored information is reset by buffering in the de-interleave memory the initialization code D_{CNT} supplied as switchover code Da from the switchover unit 4, such a buffering will need a longer time than rewriting the information stored in the de-interleave memory into the same information as the initialization code D_{CNT}. Nevertheless, it is possible to more promptly carry out an original Viterbi decoding than a conventional receiver discussed in the above-described prior art, i.e., a conventional receiver which receives an influence of the information buffered before its reception frequency was changed and performs the Viterbi decoding.

When discussing the performance or the like of the digital receiver 1 formed according to the present embodiment, what can be considered maybe as follows. Namely, judgment code Da is directly supplied to the de-interleave unit 5 without passing through the switchover unit 4. When a reception condition has deteriorated, a predetermined weight will be applied to the output (demodulation code) Dsin of the de-interleave unit 5, thereby supplying the initialization code D_{CLR} to the de-interleave unit 5. However, better constitution wouldbe that of the present embodiment in which judgment code Da or initialization code D_{CLR} is supplied through the switchover unit 4 to the de-interleave unit 5 depending on whether or not a reception condition is acceptable, thereby obtaining an effect of being able to perform a decoding process having a high designing freedom and a high processing reliability.

Although the description of the above embodiment shows that the digital receiver 1 is composed of so-called hardware, it is also possible to prepare a computer program which exhibits the same functions as those of various elements shown in Fig. 3, which computer program is executed by a microprocessor (MPU) or a digital signal processor (DSP), thereby carrying out a decoding process. Namely, the present invention should not be limited to an example in which the digital receiver 1 is composed of so-called hardware, and it is possible for the same functions to be covered by a software based on a computer program.

### [Example]

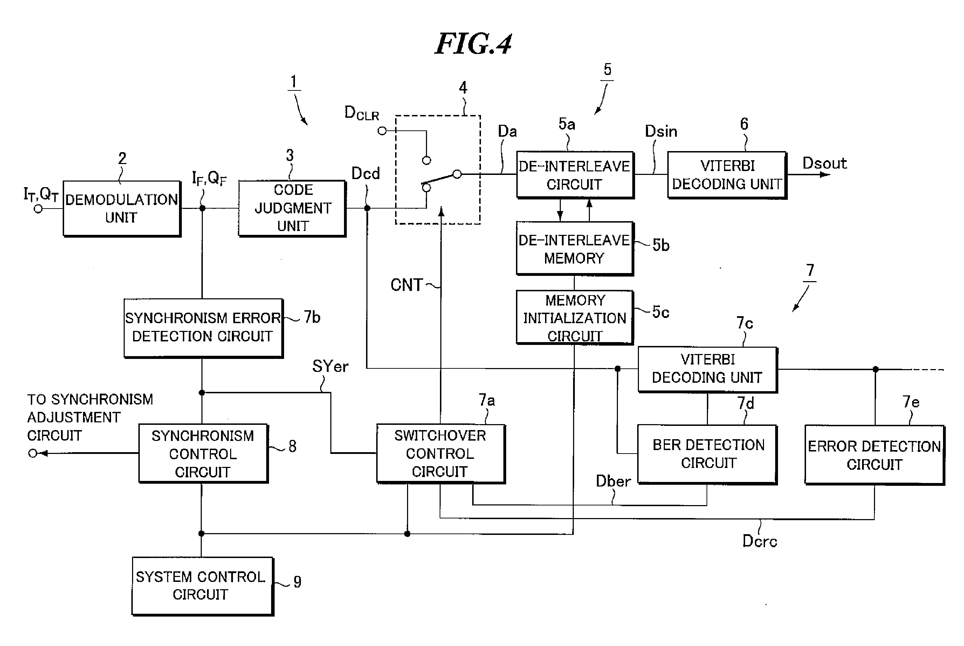

Next, description will be given to explain a more detailed embodiment with reference to Fig. 4. Fig. 4 is a block diagram showing the composition of the digital receiver of the present embodiment, using the same reference numerals to represent the elements which are the same as or corresponding to those shown in Fig. 3.

As shown in Fig. 4, the digital receiver 1 of the present embodiment comprises not only the digital demodulation unit 2, the code judgment unit 3, the switchover unit 4, the de-interleave unit 5, the Viterbi decoding unit 6 and the control unit 7, but also a synchronism control circuit 8 and a system control unit 9.

During a reception the demodulation unit 2 A/D-converts quadrature-detected base band signals I_{T}, Q_{T} and then receives the same, followed by performing an FFT processing or the like, thereby transforming the signals into quadrature signals I_{F} and Q_{F} which are complex data and outputting the same. For example, when receiving a terrestrial digital broadcast, the demodulation unit 2 A/D-converts quadrature-detected base band OFDM signals I_{T}, Q_{T} and then receives the same, followed by performing an FFT processing or the like, thereby transforming the signals into quadrature signals I_{F}, Q_{F} and outputting the same.

The code judgment unit 3 performs code judgment on the quadrature signals I_{F} and Q_{F}. When it is possible to decide signal point on constellation, the code judgment unit 3 will generate and output judgment code Dcd corresponding to coordinate position of the signal point. On the other hand, when it is impossible to decide signal point on constellation, the code judgment unit 3 will output, as judgment code Dcd, code D₀₀ formed when the coordinate positions of the I-axis and Q-axis on constellation are all 0.

The switchover unit 4 is formed of a switching element having two inputs and one output, which receives initialization code D_{CLR} and judgment code Dcd set at a value to be neglected in Viterbi decoding. Then, in accordance with a switchover control signal CNT outputted from a switchover control unit 7a, either a judgment code Dcd or an initialization code D_{CLR} is selected, while a selected code is supplied as a switchover code Da to the de-interleave unit 5.

The de-interleave unit 5 comprises a de-interleave circuit 5a, a de-interleave memory 5b, and a memory initialization circuit 5c. The judgment code Dcd or the initialization code D_{CLR} supplied from the switchover unit 4 is continuously buffered in a predetermined quantity into the de-interleave memory 5b, while the de-interleave circuit 5a performs time de-interleave, thereby supplying the modulation code Dsin which has been time de-interleaved to the Viterbi decoding unit 6. Furthermore, the memory initialization circuit 5c is provided such that once it receives an instruction from the bellowed-mentioned system control circuit 9 indicating that a reception frequency has been changed, it will supply the same information as the initialization code D_{CLK} to the de-interleave memory 5b, reset the information which has already been stored and rewrite the information into the same information as the initialization code D_{CLK}, followed by storing the switchover code Da supplied from the switchover unit 4.

The Viterbi decoding unit 6 Viterbi-decodes the demodulation code Dsin which has been time de-interleaved by the de-interleave circuit 5a, thereby generating and thus outputting the demodulation signal Dsout consisting of code equivalent to the information code (namely, code before coding) transmitted from the broadcast station side.

The control unit 7 includes the above-mentioned switchover unit 7a, a synchronism error detection circuit 7b, a Viterbi decoding unit 7c, a BER detection circuit 7d, and an error detection circuit 7e.

Here, the synchronism error detection circuit 7b performs a synchronism error detection in accordance with the quadrature signals I_{F} and Q_{F} outputted from the demodulation unit 2, thereby supplying the detected synchronism error SYer to the switchover control unit 7a and the synchronism control circuit 8.

Among the judgment codes outputted from the code judgment unit 3, those not time-interleaved are inputted into the Viterbi decoding unit 7c which performs Viterbi decoding, thereby generating and thus outputting decoded data (not assigned with reference numerals) .

The BER detection circuit 7d detects the bit error rate (BER) of the foregoing data decoded in the Viterbi decoding unit 7c, thereby supplying error data Dber indicating the detection result to the switchover control circuit 7a.

The error detection unit 7e performs a cyclic redundancy check on the foregoing data decoded in the Viterbi decoding unit 7c, so as to detect the presence of an error and supply error data Dcer indicating the detection result to the switchover control circuit 7a.

The switchover control circuit 7a judges whether a reception condition is acceptable in view of various data SYer, Dber, and Dcrc indicating a synchronism error, a bit error rate, and a cyclic redundancy check. If a reception condition is acceptable, the switchover unit 4 will be connected to the code judgment unit 3 by virtue of a switchover control signal CNT, thereby transmitting a judgment code Dcd as switchover code Da to the de-interleave circuit 5a. On the other hand, if a reception condition has deteriorated, the switchover unit 4 will be disconnected from the code judgment unit 3 by virtue of the switchover control signal CNT, thereby transmitting an initialization code D_{CLR} as switchover code Da to the de-interleave circuit 5a.

Here, when a synchronism error is smaller than a predetermined value, the switchover control circuit 7a will judge that a reception condition at this time is acceptable. On the other hand, if a synchronism error is larger than a predetermined value, the switchover control circuit 7a will judge that a reception condition at this time has deteriorated. Further, whether or not a reception condition is acceptable can also be judged by investigating whether a bit error rate has become a value equivalent to reception condition deterioration with respect to a predetermined value. Moreover, if the result of a cyclic redundancy check is acceptable, a reception condition at this time can be judged as being acceptable. On the other hand, if the result of a cyclic redundancy check is not acceptable, a reception condition at this time will be judged as being unacceptable. Besides, if any one of the results of the above pre-judgments including synchronism error check, bit error rate check and cyclic redundancy check shows that a reception condition has deteriorated, an initialization code D_{CLR} will be outputted from the switchover unit 4 to the de-interleave circuit 5a. On the other hand, if all the results of synchronism error check, bit error rate check and cyclic redundancy check show that a reception condition is acceptable, it can be finally decided that a reception condition is acceptable, and the switchover unit 4 will be connected to the code judgment unit 3, thereby transmitting the demodulation code Dcd to the de-interleave circuit 5a.

The synchronism control circuit 8 judges whether a reception is in synchronism with a channel of a broadcast station specified by the system control circuit 9, in accordance with a synchronism error data SYer fed from the synchronism error detection circuit 7b, followed by supplying the judgment result to a synchronism adjustment circuit such as LL circuit, thereby effecting a fine adjustment for a synchronized reception.

The system control circuit 9 concentrically controls an entire operation of the digital receiver 1 formed according to the present embodiment, in response to an operation instruction of a user supplied through an operating unit (not shown).

For example, when a channel of a broadcast station is specified or changed by a user, the system control circuit 9 will control the digital receiver 1 of the present embodiment to perform a synchronized reception of the channel. Further, the system control circuit 9 sends to the memory initialization circuit 5c an instruction indicating that a reception frequency has been changed, thereby performing a processing for rewriting into the de-interleave memory 5b the same information as the initialization code D_{CLR}. Moreover, the system control circuit 9 performs various controls so that once there is an instruction for starting seeking and searching in order to automatically search for and preset a channel of a broadcast station having an acceptable reception state, a reception frequency will be automatically changed, thereby automatically searching for and resetting a channel of a broadcast station having an acceptable reception state. In addition, once a reception frequency is changed during the seeking and searching, the system control circuit 9 will send to the memory initialization circuit 5c an instruction indicating that a reception frequency has been changed, thereby performing a processing for rewriting into the de-interleave memory 5b the same information as the initialization code D_{CLR}.

Next, description will be given to explain an operation of the digital receiver 1 of the present embodiment having the foregoing structure. However, the following description will explain a typical example in which a reception condition has deteriorated from an acceptable state and then returned to the acceptable state.

Once a reception condition deteriorates and at least one of the synchronism error detection circuit 7b, the RER detection circuit 7d and the error detection unit 7e detects that a reception condition has deteriorated, the switchover control circuit 7a will judge that the reception condition has deteriorated in accordance with data SYer, Dber, and Dcrc, so as to control the switchover unit 4 to supply the initialization code D_{CLR} as switchover code Da to the interleave circuit 5a, thereby performing Viterbi decoding in the Viterbi decoding unit 6. Accordingly, when a reception condition has deteriorated, it is inevitable that the Viterbi decoding unit 6 will cease to output decoded signal Dsout which is effective in relation to broadcasting.

Next, once a reception condition changes from an unacceptable state to an acceptable state, the switchover control circuit 7a will judge that a reception condition is in an acceptable state in accordance with data SYer, Dber, and Dcrc, so as to control the switchover unit 4 to supply the judgment code D_{CD} as switchover code Da to the interleave circuit 5a. Further, the interleave circuit 5a will time de-interleave the judgment code D_{CD} into the demodulation code Dsin and supply the same to the Viterbi decoding unit 6, thereby effecting a Viterbi decoding.

Here, immediately after a reception condition has changed from an unacceptable state to an acceptable state, since the initialization code D_{CLR} buffered in the de-interleave memory 5b will become demodulation code Dsin and will be supplied from the de-interleave memory 5b to the Viterbi decoding unit 6, the Viterbi decoding will be carried out in accordance with a demodulation code Dsin formed when a reception condition has deteriorated and another demodulation code Dsin formed when a reception condition has become acceptable. However, since the demodulation code Dsin formed when a reception condition has deteriorated is not a code which reflects a deteriorated reception condition as such and then changes the same, but a code which does not apply any influence to the assumption of Viterbi, the Viterbi decoding unit 6 can specify a path on which an inter-code distance will become minimum, and judge that an information code corresponding to the state transition of the foregoing path is a code having the maximum likelihood, thereby making it possible to shorten a time period before it becomes possible to obtain an information not containing any error.

For this reason, once a reception condition changes from an unacceptable state to an acceptable state, it is possible for the Viterbi decoding unit 6 to quickly exhibit an original error correcting capability and perform a Viterbi decoding.

As described above, the digital receiver 1 of the present embodiment is so fabricated that when a reception condition is acceptable, the judgment code Dcd after code judgment will be supplied as switchover code Da to the Viterbi decoding unit 6 by way of the de-interleave unit 5. On the other hand, when a reception condition has deteriorated, an initialization code D_{CLR} will be supplied as switchover code Da to the Viterbi decoding unit 6 by way of the de-interleave unit 5. As a result, when a reception condition has deteriorated and then returned back to an acceptable state, it is possible to quickly exhibit an original error correcting capability and perform a Viterbi decoding.

Moreover, when a reception condition has deteriorated within a short time period during a reception, it is possible to reduce an occurrence of noise, and it is possible to reduce a necessity of performing an appropriate mute processing for noise abasement. Namely, it is possible to obtain an effect of dispensing with a precise mute adjustment which will generally confront some difficulties.

Further, when a reception frequency is changed in accordance with an instruction of a user or the like specifying a switchover to his or her desired broadcast channel, or when a reception frequency is changed for automatically selecting a broadcast channel by seeking or searching for a channel of a broadcast station having an acceptable reception state, it is possible to effect the following operations. Namely, the memory initialization circuit 5c will at an early time automatically rewrite the information stored in the de-interleave memory 5b into the same information as the initialization code D_{CNT}, buffer the judgment signal Dcd whose reception frequency has been changed, thereby carrying out a time de-interleave by virtue of the de-interleave circuit 5a. In this way, it is possible to quickly effect an original Viterbi decoding without receiving an influence of the information buffered in the de-interleave memory before its reception frequency was changed.

In addition, the digital receiver 1 of the present embodiment is similar to the digital receiver described in relation to the foregoing embodiment. Namely, when a reception frequency is to be changed, an initialization code D_{CNT} supplied as switchover code Da from the switchover unit 4 may be buttered in the de-interleave memory.

In this way, when the stored information is reset by buffering in the de-interleave memory the initialization code D_{CNT} supplied as switchover code Da from the switchover unit 4, such a buffering will need a longer time than rewriting the information stored in the de-interleave memory into the same information as the initialization code D_{CNT}. Nevertheless, it is possible to more promptly carry out an original Viterbi decoding than a conventional receiver discussed in the above-described prior art, i.e., a conventional receiver which receives an influence of the information buffered before its reception frequency was changed and performs the Viterbi decoding. Moreover, since it is possible to dispense with the memory initialization circuit 5c, it becomes possible to simplify a circuit scale or the like.

Although the description of the above embodiment shows that the digital receiver 1 is composed of so-called hardware, it is also possible to prepare a computer program which exhibits the same functions as those of various elements shown in Fig. 4, which computer program is executed by a microprocessor (MPU) or a digital signal processor (DSP), thereby effecting a decoding process. Namely, the present invention should not be limited to an example in which the digital receiver 1 is composed of so-called hardware, and it is possible for the same functions to be covered by a software based on a computer program.

## Claims

1. A digital receiver which receives a digital broadcast, comprising:
code judgment means which outputs a judgment code by performing code judgment on signals demodulated by demodulation means;
switchover means which selects and outputs the judgment code or an initialization code not affecting presumption of Viterbi;
de-interleave means for de-interleaving a code outputted from the switchover means;
Viterbi decoding means for generating a decoded signal by Viterbi-decoding a code de-interleaved by the de-interleave means; and
control means which judges a reception condition and which, when a reception condition is acceptable, controls the switchover means to supply the judgment code outputted from the code judgment means to the de-interleave means, and when a reception condition has deteriorated, controls the switchover means to supply the initialization code to the de-interleave means.

2. The digital receiver according to claim 1, wherein the control means judges whether a reception condition is acceptable in accordance with a detection result outputted from at least one of the following detection means including:
synchronism error detection means for performing a synchronism detection on the signals demodulated by the demodulation means and detecting a synchronism error;
bit error rate detection means for detecting a bit error rate of the judgment code outputted from the code judgment means; and
error detection means for performing a cyclic redundancy check on the judgment code outputted from the code judgment means.

3. The digital receiver according to claim 1 or 2, wherein the de-interleave means includes memory means for buffering a predetermined amount of the code outputted from the switchover means, de-interleaves the code buffered in the memory means and outputs the code to the Viterbi decoding means.

4. The digital receiver according to claim 3, wherein the de-interleave means includes memory control means for rewriting the information stored in the memory means into the same information as the initialization code.

5. A decoding method for use in a digital receiver which receives a digital broadcast, said method comprising:
a code judgment step which generates a judgment code by performing code judgment on signals demodulated in a demodulation step;
a switchover step which selects and outputs the judgment code or an initialization code not affecting presumption of Viterbi;
a de-interleave step for de-interleaving a code outputted from the switchover step;
a Viterbi decoding step for generating a decoded signal by Viterbi-decoding a code de-interleaved in the de-interleave step; and
a control step which judges a reception condition and which, when a reception condition is acceptable, controls the switchover step to supply the judgment code to the de-interleave step, and when a reception condition has deteriorated, controls the switchover step to supply the initialization code to the de-interleave step.
